# EUROPEAN PATENT APPLICATION

(11) **EP 2 541 759 A1**
(43) Date of publication of application: **02.01.2013**
(21) Application number: 11842465.4
(22) Date of filing: 27.10.2011
(51) Int. Cl.: H03F 1/02

(54) **DOHERTY POWER AMPLIFIER AND IMPLEMENTATION METHOD THEREFOR**

(30) Priority: 29.04.2011 CN 201110110313
(71) Applicant: ZTE Corporation, Shenzhen, Guangdong 518057 (CN)
(72) Inventor: CHEN, Huazhang, Guangdong Province 518057 (CN); LIU, Jiamli, Guangdong Province 518057 (CN); CUI, Xiaojun, Guangdong Province 518057 (CN)
(74) Representative: Willquist, Sofia Ellinor
(86) International application number: PCT/CN2011/081398
(87) International publication number: WO 2012/146007

(57) **Abstract**

The present invention discloses a Doherty power amplifier and an implementation method thereof. The Doherty power amplifier includes a carrier power amplifier circuit and a peak power amplifier circuit, wherein, the peak amplifier circuit is configured with a Radio Frequency (RF) switch for controlling turn-on of peak power amplifiers in the peak amplifier circuit; and a part or all of carrier power amplifiers in the carrier power amplifier circuit use GaN devices, and a part or all of the peak power amplifiers in the peak power amplifier circuit use LDMOS devices. The present invention avoids a defect of a peak branch in the Doherty power amplifier from being turned on ahead of time, thus reducing the power consumption of the peak power amplifier; and meanwhile, since the power consumption of the carrier power amplifiers in the Doherty power amplifier account for most of the power consumption, and the efficiency of the carrier power amplifiers using GaN devices is much higher than that of the carrier power amplifiers using LDMOS devices, the efficiency of the whole power amplifier is greatly enhanced.

## Description

### Technical Field

The present invention relates to the field of communication technologies, and in particular, to a Doherty power amplifier and an implementation method thereof.

### Background of the Related Art

With greens environmental protection and low-carbon economy concepts becomes deeply rooted among the people continuously around the world, requirements of operators for reduction of power consumption of a wireless communication system also become increasing high. In the wireless communication system, a Radio Frequency (RF) power amplifier (power amplifier for short) in a base station device is one of core modules of the whole system, and an important index of the RF power amplifier is the efficiency of the power amplifier. It is indicated from data analysis that in the whole base station device, the energy consumption of the power amplifier portion accounts for about 60% of the overall energy consumption, and therefore, enhancing the efficiency of the power amplifier becomes the most efficient means to reduce the power consumption of the base station device and reduce the operator's Operating Expense (OPEX). Therefore, in the face of the increasingly intensive market competition for wireless communications, high efficient RF power amplifier technologies have become one of focuses of competition in the wireless communication industry.

A Doherty power amplifier is a high efficient power amplifier technology which is the most widely applied currently in the wireless communication system, and was invented by a U.S. Electronics Engineer named William H. Doherty in 1936. However, in the next about thirty years, people diverted their attention. Until the late 1960s, with the development of the communications technology, especially of the satellite communications, the problem of the efficiency and linearity of the power amplifier was re-submitted in a new historical occasion, and the Doherty amplifier was excavated again and was widely used in communication and broadcasting systems in the 1970s. At present, the Doherty power amplifier is applied with the Digital Pre-Distortion (DPD) technology, and has become a mainstream architecture form of a high efficient power amplifier of a base station in a wireless communication system.

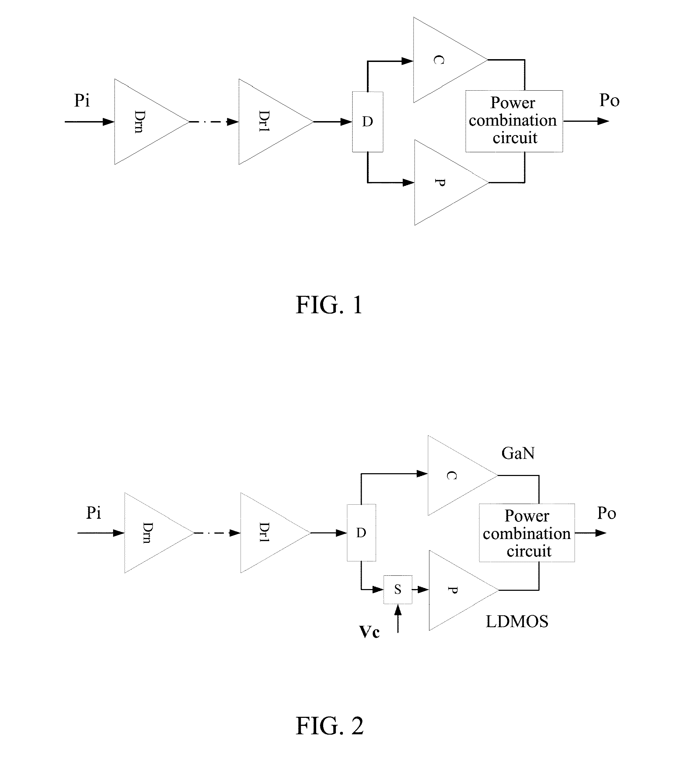

The basic idea of the Doherty power amplifier is an active load-pull, and the principle of a conventional Doherty power amplifier is shown in FIG. 1, a conventional Doherty power amplifier primarily comprises a drive stage amplifier (Dr1 ... Drn in the figure), a power distributor (D in the figure), a carrier amplifier (C in the figure, which is also referred to as a main power amplifier), a peak amplifier (P in the figure, which is also referred to as an auxiliary power amplifier), a power combination circuit (Combiner in the figure) , etc. Wherein, the carrier power amplifier operates in class B or AB, and the peak power amplifier operates in class C. Both bear different input signal powers respectively, and need to make their power amplifiers operate in respective saturation areas as much as possible, thus ensuring that the whole power amplifier maintains a high efficiency in a large range of the input signal power as much as possible, and meanwhile ensuring a certain linearity.

The Doherty power amplifier primarily comprises the following three operating states:
small signal area. When the input signal is small, the peak amplifier is in an off state, and the carrier amplifier operates in class AB, and at this time, the carrier amplifier operates in a matching state with a maximum efficiency;
load modulation area. When the input signal increases to a certain extent, the carrier amplifier gradually transitions from an amplification area to a saturation area, and the peak amplifier gradually transitions from a cut-off area to the amplification area, and at this time, the load of the carrier amplifier and the peak amplifier are both unstable, and the load impendence changes with the power; and
saturation area. With the continuous increase of the input signal, both the carrier amplifier and the peak amplifier finally operate in the saturation state, and both correspond to a 50Ωload, and the output powers are added.

### Summary of the Invention

The technical problem to be solved by the present invention is to provide a Doherty power amplifier and an implementation method thereof, which avoids increasing peak power consumption when a peak amplifier is turned on ahead of time, and meanwhile enhances the efficiency of the whole peak power amplifier.

In order to solve the above technical problem, the present invention provides a Doherty power amplifier, comprising a carrier power amplifier circuit and a peak power amplifier circuit, wherein,
the peak power amplifier circuit is configured with a RF switch, which is configured to control turn-on of peak power amplifiers in the peak power amplifier circuit; and
a part or all of carrier power amplifiers in the carrier power amplifier circuit use Gallium Nitride (GaN) devices, and a part or all of peak power amplifiers in the peak power amplifier circuit use Laterally Diffused Metal Oxide Semiconductor (LDMOS) devices.

Alternatively, the carrier power amplifier circuit comprises one-path or multi-path carrier power amplifier branches, and each path carrier power amplifier branch comprises one-stage or multi-stage carrier power amplifiers; wherein, a last stage carrier power amplifier uses GaN devices.

Alternatively, the peak power amplifier circuit comprises one-path or multi-path peak power amplifier branches, and each path peak power amplifier branch comprises one-stage or multi-stage peak power amplifiers; wherein, a last stage peak power amplifier uses LDMOS devices.

Alternatively, each path peak power amplifier branch of the peak power amplifier circuit is configured with the RF switch.

Alternatively, when the peak power amplifier branch comprises multi-stage peak power amplifiers, the RF switch is configured between a drive stage peak power amplifier and the last stage peak power amplifier, and the RF switch is configured to control turn-on of the last stage peak power amplifier.

The present invention further provides a method for implementing a Doherty power amplifier, comprising:
setting a RF switch in a peak power amplifier circuit of the Doherty power amplifier, and controlling turn-on of peak power amplifiers in the peak power amplifier circuit by the RF switch;
wherein, a part or all of carrier power amplifiers in the carrier power amplifier circuit of the Doherty power amplifier use GaN devices, and a part or all of peak power amplifiers in the peak power amplifier circuit use LDMOS devices.

Alternatively, the carrier power amplifier circuit comprises one-path or multi-path carrier power amplifier branches, and each path carrier power amplifier branch comprises one-stage or multi-stage carrier power amplifiers; wherein, a last stage carrier power amplifier uses GaN devices.

Alternatively, the peak power amplifier circuit comprises one-path or multi-path peak power amplifier branches, and each path peak power amplifier branch comprises one-stage or multi-stage peak power amplifiers; wherein, a last stage peak power amplifier uses LDMOS devices.

Alternatively, the step of setting a RF switch in a peak power amplifier circuit of the Doherty power amplifier comprises:
setting the RF switch in each path peak power amplifier branch in the peak power amplifier circuit; and
setting the RF switch between a drive stage peak power amplifier and the last stage peak power amplifier when the peak power amplifier branch comprises multi-stage peak power amplifiers.

Alternatively, the step of controlling turn-on of a peak power amplifier in the peak power amplifier circuit through the RF switch comprises controlling turn-on of the last stage peak power amplifier in the peak power amplifier branch by the RF switch.

Compared to the related art, the above scheme at least has the following advantages:
a)high efficiency, which avoids the disadvantage of the peak branch in the Doherty power amplifier from being turned on ahead of time, reduces the power consumption of the peak power amplifier, and enhances the mass efficiency of the whole power amplifier. In the Doherty power amplifier without using the above scheme, the power consumption of the peak power amplifier generally accounts for 10%-20% of the overall power consumption of the power amplifier, and after using the above scheme, such proportion value can be reduced to 5%-10%. Meanwhile, as the power consumption of the carrier power amplifier in the Doherty power amplifier accounts for most of the power consumption and the efficiency of the carrier power amplifiers using GaN devices is much higher than that of the carrier power amplifiers using LDMOS devices, the efficiency of the whole power amplifier is greatly enhanced;
b)low expense, which largely reduces the product expense and production expense of the power amplifier compared to the scheme of some manufacturers improving on-time of the peak power amplifier using complex digital circuits and RF circuits; and the expense of the scheme of the last stage amplification of GaN+LDMOS is much lower than the high efficient scheme of both paths being GaN devices; and
c)small volume, which accounts for a much smaller volume compared to the scheme of some manufacturers improving on-time of the peak power amplifier using complex digital circuits and RF circuits.

### Brief Description of Drawings

The accompanying drawings illustrated here are used to provide further understanding of the present invention, and constitute a part of the present application. The schematic examples of the present invention and illustration thereof are used to explain the present invention, instead of constituting improper limitation of the present invention. In the accompanying drawings:
FIG. 1 is a schematic block diagram of a traditional Doherty power amplifier;
FIG. 2 is a principle block diagram of an embodiment of the present invention being applied to dual-path Doherty architecture;
FIG. 3 is a principle block diagram of an embodiment of the present invention being applied to multi-stage multi-path Doherty architecture; and
FIG. 4 is a schematic block diagram of application examples of the present invention being applied to a UMTS 2.1 GHz band 85W power amplifier.

### Preferred Embodiments of the Present Invention

The requirements of operators for the communication system is that the lower the power consumption, the better, and the higher the efficiency, the better. Therefore, we must constantly seek a method to further reduce power consumption and enhance efficiency. While the traditional Doherty power amplifier primarily has the following disadvantages:
1) in theory, the power consumption of the peak power amplifier of the Doherty power amplifier is very small; however, in the actual power amplifier, the power consumption of the peak power amplifier accounts for 10% -20%. It's because that in the Doherty power amplifier, the peak power amplifier operates in class C and the peak amplifier will not be turned on when the peak power amplifier operates at a small signal, and that when the amplification signal gradually becomes large to a certain extent from small, the carrier amplifier starts to have a compression trend, and at this time, the peak amplifier must be able to operate normally in an on state; otherwise, the improvements of the DPD on the linearity of the power amplifier will be influenced. While a class C amplifier is turned on gradually with a signal from small to large, and therefore, in the actual application, in order to enable the peak amplifier to be turned on completely when the carrier amplifier starts to compress, the peak amplifier must be turned on ahead of time at a lower level, thus increasing the power consumption of the peak power amplifier, and reducing the efficiency of the whole power amplifier.
2) the carrier power amplifiers and the peak power amplifiers of the existing Doherty power amplifier both use LDMOS power amplifier device, which have disadvantages such as low operating frequencies, narrow working bandwidth, low efficiency, high power consumption, etc.

The embodiments of the present invention reduce the power consumption of peak amplification by controlling turn-on and turn-off of a signal of a peak amplification branch of a Doherty power amplifier; and meanwhile further enhance the efficiency of the whole power amplifier by selecting a model of the last stage power amplifier device.

Specifically, the embodiments of the present invention avoid the peak power amplifier from being turned on ahead of time and thus reduce the power consumption of the peak power amplifier by adding a RF switching circuit in the Doherty peak amplification branch and turning on a RF switch only when an input signal is increased to a suitable amplitude to cause the peak power amplifier to be turned on; and meanwhile, the last stage power amplifier is implemented using a combination of GaN and LDMOS to further enhance the efficiency of the whole power amplifier.

The examples of the present invention will be described in detail in conjunction with accompanying drawings hereinafter. It should be illustrated that in the condition without conflict, the examples and features in the examples in the present application can be randomly combined with each other.

FIG. 2 illustrates a block diagram of the embodiments of the present invention being applied to dual-path Doherty architecture. In the figure, Pi is an input signal port; Dr1 ...Drn are drive stage amplifiers; C is a carrier amplifier; P is a peak amplifier; S is a RF switching circuit; Vc is a control voltage of a RF switch (the change of the Vc can adjust a on-level of the RF switch), D is a power splitter circuit, Combiner is a power combination circuit, and Po is a signal output port.

In conjunction with FIG. 2, the process of controlling the peak amplifier by the RF switching circuit according to an embodiment of the present invention is described as follows:
when the input signal of the peak amplification branch is small (lower than the on-level of the RF switch), the whole peak amplification branch is in an off state, and at this time, the whole carrier amplification branch operates in a AB class state matching with maximum efficiency;
when the input signal of the peak amplification branch increases to a certain extent, the carrier amplification branch starts to transitions from an amplification area to a saturation area gradually, the peak amplification branch transitions from a cut-off area to the amplification area, and the peak power amplifier is not turned on at first, and thus does not have power consumption. When the signal input into the peak branch reaches the on-level of the RF switch, the RF switch is turned on, and the peak power amplifier is completely turned on therewith. Thus, the peak power amplifier is avoided from being turned on ahead of time, which reduces the power consumption and enhances the efficiency of the power amplifier;
in addition, It can adjust the on-level of the RF switch by changing the Vc, thus satisfying the requirements of different types of signals and different peak power amplifier devices;
at last, with the continuous increase of the input signal, both the whole carrier amplification branch and the peak amplification branch operate in a saturation state finally. As the power consumption of the carrier power amplifier in the Doherty power amplifier accounts for most of the power consumption, and in the present invention, the carrier power amplifiers use GaN device whose efficiency is much higher than LDMOS device , the efficiency of the whole power amplifier is greatly enhanced.

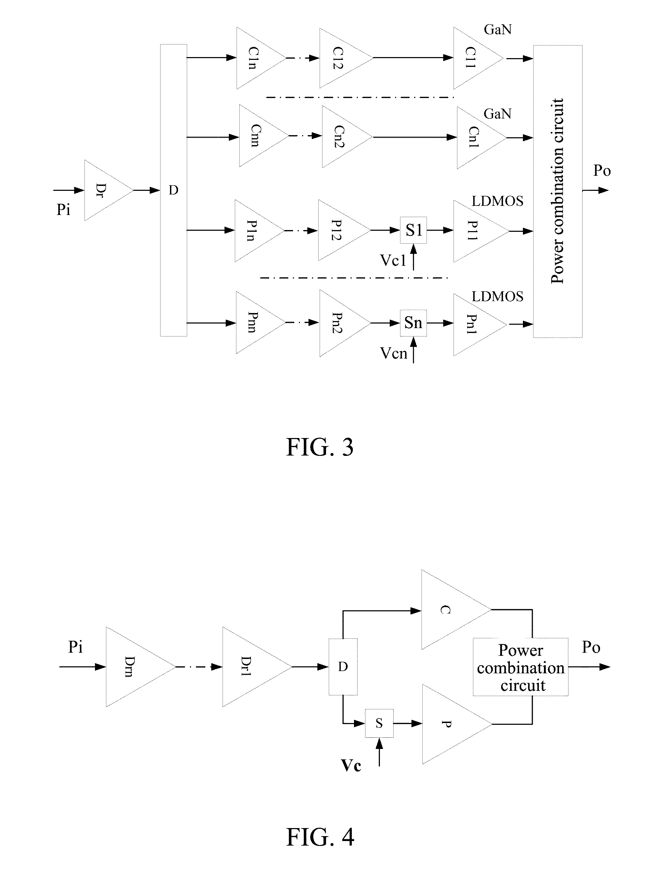

A diagram of the embodiments of the present invention being applied to multi-path multi-stage Doherty power amplifier architecture is shown in FIG. 3. In the figure, Pi is an input signal port; Dr is a drive stage amplifier; D is a power splitter; C11...Cln to Cn1...Cnn constitute 1 st to nth carrier amplification branches of the multi-stage Doherty power amplifier; P11 ... P1n to Pn1...Pnn constitute 1st to nth peak amplification branches of the multi-stage Doherty power amplifier; S1...Sn are RF switching circuits of 1st to nth peak amplification branches, and Vcl...Vcn are control voltages of corresponding RF switches (the changes of the Vc1...Vcn can adjust the on-levels of the corresponding RF switches); and Combiner is a power combination circuit. The principle of its performance improvement is similar to that of the dual-path Doherty power amplifier architecture.

In addition, the example of the present invention further provides a method for implementing controlling turn-on and turn-off of a peak amplifier by a RF switch and a method for designing Doherty. For example, the primary technical requirements of a certain UMTS power amplifier are as follows: a frequency range being 2110MHz-2170MHz, an output power being 85W, an input signal being PAR7dB, a gain being 50dB, efficiency being 42%, and linearity indexes (including ACPR, SEM, Out of Band Spurious, etc.) satisfying requirements of a standard protocol.

Specifically, the process of completing the research and development of the whole power amplifier by applying the embodiments of the present invention primarily comprises the following steps:
in step A, a form of power amplifier architecture is determined. Since the output power of the present power amplifier is 85W and the efficiency is required more than 42%, in consideration of the requirements of the technical indexes of the power amplifier and the condition of the existing devices comprehensively, the whole power amplifier is determined to use a form of the 2-dual Doherty architecture (refer to architecture of Fig. 2).
in Step B, power amplifier devices for last stage carrier amplification (C1) and last stage peak amplification (P1) are selected. According to the PAR requirements on the output power and the input signal, the GaN power amplifier device CGH21120F of the CREE company is selected as a last stage carrier amplification device, and the LDMOS power amplifier device BLF7G20LS-200 of the NXP company is selected as a last stage peak amplification device. The GaN power amplifier device is a new type of RF power device, which has disadvantages such as high operating frequencies, broad working bandwidth, high efficiency, a small volume, etc. compared to the LDMOS, and the application of the combination of the GaN power amplifier device and the LDMOS power amplifier device implements a good balance between high performance and low expense.
in step C, a drive stage device is selected. In consideration of requirements from various aspects, the GaN power amplifier device CGH40045 of the CREE company is selected as the drive stage device, and the SXA-389Z of the RFMD company is selected as a first drive stage amplification device.
in step D, the RF switching circuit of the peak amplification branch is completed. The implementation of the circuit comprises a variety of forms such as a PIN diode RF switch, a Monolithic Microwave Integrated Circuit (MMIC) RF switch, etc., and the switching circuit must be able to be turned on quickly according to the requirements.
in step E, designs of other circuits such as temperature compensators, circulators, couplers etc. are completed, and the principle diagram of the whole power amplifier and the PCB design are finally completed; and
in step F, the debug and test of the whole power amplifier are completed.

The above description is only the preferred embodiments of the present invention and is not intended to limit the protection scope of the present invention. The invention can have a variety of other embodiments, and for those skilled in the art, various corresponding changes and variations can be made according to the present invention without departing from the spirit and substance of the present invention, and all these corresponding changes and variations should belong to the protection scope of the appended claims of the present invention.

Obviously, those skilled in the art should understand that the above various modules or various steps of the present invention can be implemented by a general purpose computing apparatus, can be integrated on a single computing apparatus, or distributed across a network comprised of a plurality of computing apparatuses; alternatively, the various modules and steps can be implemented by program codes executable by computer apparatuses, and thus can be stored in a storage apparatus to be executed by the computer apparatuses, and in some cases, the illustrated or described steps can be implemented in a different order from here, or can be implemented by being made into various IC modules respectively or by making multiple modules or steps therein into a single IC module. Thus, the present invention is not limited to any particular combination of hardware and software.

### Industrial Applicability

The above embodiments have the following advantages:
a) high efficiency, which avoids the disadvantage of the peak branch in the Doherty power amplifier being turned on ahead of time, reduces the power consumption of the peak power amplifier, enhances the mass efficiency of the whole power amplifier. In the Doherty power amplifier without using the above scheme, the power consumption of the peak power amplifier generally accounts for 10%-20% of the overall power consumption of the power amplifier, and after using the above scheme, such proportion value can be reduced to 5%-10%. Meanwhile, as the power consumption of the carrier power amplifier in the Doherty power amplifier accounts for most of the power consumption and the efficiency of the carrier power amplifiers using GaN devices is much higher than that of the carrier power amplifiers using LDMOS devices, the efficiency of the whole power amplifier is greatly enhanced.
b) low expense. The present invention largely reduces the product expense and production expense of the power amplifier compared to the scheme of some manufacturers improving on-time of the peak power amplifier using complex digital circuits and RF circuits; and the expense of the scheme of the last stage amplification of GaN+LDMOS is much lower than the high efficient scheme of both paths being GaN devices.
c) small volume. The present invention accounts for a much smaller volume compared to the scheme of some manufacturers improving on-time of the peak power amplifier using complex digital circuits and RF circuits.

## Claims

1. A Doherty power amplifier, comprising a carrier power amplifier circuit and a peak power amplifier circuit, wherein,
the peak power amplifier circuit is configured with a Radio Frequency (RF) switch, which is configured to control turn-on of peak power amplifiers in the peak power amplifier circuit; and
a part or all of carrier power amplifiers in the carrier power amplifier circuit use Gallium Nitride (GaN) devices, and a part or all of the peak power amplifiers in the peak power amplifier circuit use Laterally Diffused Metal Oxide Semiconductor (LDMOS) devices.

2. The power amplifier according to claim 1, wherein,
the carrier power amplifier circuit comprises one-path or multi-path carrier power amplifier branches, and each path carrier power amplifier branch comprises one-stage or multi-stage carrier power amplifiers; wherein, a last stage carrier power amplifier uses the GaN devices.

3. The power amplifier according to claim 1, wherein,
the peak power amplifier circuit comprises one-path or multi-path peak power amplifier branches, and each path peak power amplifier branch comprises one-stage or multi-stage peak power amplifiers; wherein, a last stage peak power amplifier uses the LDMOS devices.

4. The power amplifier according to claim 3, wherein,
each path peak power amplifier branch of the peak power amplifier circuit is configured with the RF switch.

5. The power amplifier according to claim 3 or 4, wherein,
when the peak power amplifier branch comprises multi-stage peak power amplifiers, the RF switch is configured between a drive stage peak power amplifier and the last stage peak power amplifier, and the RF switch is configured to control turn-on of the last stage peak power amplifier.

6. A method for implementing a Doherty power amplifier, comprising:
setting a Radio Frequency (RF) switch in a peak power amplifier circuit of the Doherty power amplifier, and controlling turn-on of peak power amplifiers in the peak power amplifier circuit by the RF switch;
wherein, a part or all of carrier power amplifiers in a carrier power amplifier circuit of the Doherty power amplifier use Gallium Nitride (GaN) devices, and a part or all of the peak power amplifiers in the peak power amplifier circuit use Laterally Diffused Metal Oxide Semiconductor (LDMOS) devices.

7. The method according to claim 6, wherein,
the carrier power amplifier circuit comprises one-path or multi-path carrier power amplifier branches, and each path carrier power amplifier branch comprises one-stage or multi-stage carrier power amplifiers; wherein, a last stage carrier power amplifier uses the GaN devices.

8. The method according to claim 6, wherein,
the peak power amplifier circuit comprises one-path or multi-path peak power amplifier branches, and each path peak power amplifier branch comprises one-stage or multi-stage peak power amplifiers; wherein, a last stage peak power amplifier uses the LDMOS devices.

9. The method according to claim 8, wherein,
the step of setting a RF switch in a peak power amplifier circuit of the Doherty power amplifier comprises:
setting the RF switch in each path peak power amplifier branch in the peak power amplifier circuit; and
setting the RF switch between a drive stage peak power amplifier and the last stage peak power amplifier when the peak power amplifier branch comprises multi-stage peak power amplifiers.

10. The method according to claim 8 or 9, wherein,
the step of controlling turn-on of peak power amplifiers in the peak power amplifier circuit by the RF switch comprises controlling turn-on of the last stage peak power amplifier in the peak power amplifier branch by the RF switch.
